# EUROPÄISCHE PATENTSCHRIFT

(11) **EP 3 526 823 B1**
(45) Veröffentlichungstag und Bekanntmachung des Hinweises auf die Patenterteilung: **09.12.2020**
(21) Anmeldenummer: 17832729.2
(22) Anmeldetag: 12.10.2017
(51) Int. Cl.: H01L 41/09, H01L 41/047, H02N 2/00

(54) **ULTRASCHALLMOTOR**
ULTRASONIC MOTOR
MOTEUR À ULTRASONS

(30) Priorität: 13.10.2016 DE 102016119529
(43) Veröffentlichungstag der Anmeldung: 21.08.2019
(73) Patentinhaber: Physik Instrumente (PI) GmbH & Co. KG, 76228 Karlsruhe (DE)
(72) Erfinder: WISCHNEWSKIY, Wladimir, 14712 Rathenow (DE); WISCHNEWSKI, Alexej, 76744 Wörth (DE)
(74) Vertreter: Grünecker Patent- und Rechtsanwälte PartG mbB
(86) Internationale Anmeldenummer: PCT/DE2017/100865
(87) Internationale Veröffentlichungsnummer: WO 2018/068792

(56) Entgegenhaltungen:
- CN-A- 103 023 372
- DE-A1-102008 026 429
- DE-A1-102013 110 356
- DE-A1-102014 205 577

## Beschreibung

Die Erfindung betrifft einen Ultraschallmotor gemäß Anspruch 1 und ein Verfahren zum Ansteuern eines entsprechenden Ultraschallmotors gemäß Anspruch 9.

Es gibt Ultraschallmotoren, in denen der Ultraschallaktor als rechteckige piezoelektrische Platte ausgeführt ist, wie beispielsweise in der US 6,064,140 A beschrieben.

In den Aktoren dieser Motoren werden sowohl akustische Biege-Stehwellen, die sich längs zur Länge L und längs zur Breite B der piezoelektrischen Platte ausbreiten, als auch akustische Längs-Stehwellen erzeugt, die sich längs zur Länge L ausbreiten.

DE 10 2014 205577 A1 offenbart einen rechteckigen piezoelektrischen Ultraschallaktor mit streifenförmigen Erregerelektroden, der in Richtung seiner Länge in drei Generatorabschnitte unterteilt ist, wobei der zentrale Abschnitt einen Generator zur Erzeugung einer akustischen Längs-Stehwelle aufweist und die beiden peripheren Abschnitte, die beidseitig an den zentralen Abschnitt angrenzen, jeweils einen Generator zur Erzeugung einer akustischen Biege-Stehwelle aufweisen.

Die Dicke D der piezoelektrischen Platte ist aus verschiedenen Gründen auf den Wert B/4 begrenzt. Deshalb ist es bei diesen Motoren unmöglich, dass die Länge des Friktionskontaktes größer als B/4 sein kann. Das verringert einerseits die von den Motoren erzeugte maximale Kraft, und andererseits ihre mechanische Leistung.

Zur Erhöhung der Maximalkraft und der mechanischen Leistung werden üblicherweise zwei oder mehrere parallel geschaltete Motoren verwendet.

Der Nachteil einer solchen Parallelschaltung für die Praxis ist, dass die Ultraschallmotoren eine entsprechende Streuung der Betriebsfrequenzen (Resonanzfrequenzen) aufweisen. Diese Streuung ist durch die bei der Fertigung der keramischen Platte entstehende technologische Streuung der Dichte und Härte der piezoelektrischen Keramik bedingt.

Der entsprechende Unterschied in den Betriebsfrequenzen hat eine Verringerung der summierten Leistung der parallel geschalteten Motoren zur Folge und führt zu einem instabilen Betrieb, da die Betriebsfrequenz eines Motors laufend auf die eines anderen Motors springt.

Außerdem verteuert der gleichzeitige Einsatz mehrerer Motoren die Geräte, in denen diese Motoren verwendet werden.

Aufgabe der Erfindung ist es daher, sowohl eine Erhöhung der Maximalkraft und der mechanischen Leistung, als auch eine höhere Betriebsstabilität und geringere Herstellungskosten von Ultraschallmotoren zu erreichen.

Diese Aufgabe wird gelöst durch einen Ultraschallmotor nach Anspruch 1, und durch ein Verfahren zum Ansteuern eines solchen Ultraschallmotors nach Anspruch 9. Die sich an den Anspruch 1 bzw. an den Anspruch 9 anschließenden Unteransprüche stellen wenigstens zweckmäßige Weiterbildungen des jeweiligen Gegenstands dar.

Demnach wird erfindungsgemäß ausgegangen von einem Ultraschallmotor, der einen Ultraschallaktor in Form einer rechteckigen Platte mit einer Länge L, einer Breite B und einer Dicke D aus polarisiertem piezoelektrischem Material, die zwei Hauptflächen, zwei längere Seitenflächen und zwei kürzere Seitenflächen, welche Stirnflächen definieren, ein anzutreibendes Element und eine elektrische Erregervorrichtung aufweist. Der Ultraschallaktor umfasst hierbei entweder zwei oder vier Generatoren zur Anregung von akustischen Stehwellen in diesem. Weiterhin ist an dem Ultraschallaktor wenigstens ein an das anzutreibende Element gedrücktes bzw. gepresstes Friktionselement angeordnet.

Jeder der Generatoren gebildet ist aus dem entsprechenden Teil des piezoelektrischen Materials des Ultraschallaktors und daran abwechselnd angeordneten streifenförmigen allgemeinen Elektroden und Erregerelektroden.

Im Falle, dass der Ultraschallaktor zwei Generatoren zur Anregung der akustischen Stehwellen aufweist, besitzt dieser nur eine Symmetrieebene S, die senkrecht zu seinen Seitenflächen und parallel zu seinen Stirnflächen verläuft, wobei die streifenförmigen Elektroden parallel zu dieser Symmetrieebene an einer der Hauptflächen angeordnet sind, und wobei die zwei Generatoren symmetrisch zueinander bezüglich der Symmetrieebene S angeordnet sind.

Im Falle, dass der Ultraschallaktor vier Generatoren zur Anregung der akustischen Stehwellen aufweist, besitzt dieser neben der Symmetrieebene S noch eine weitere Symmetrieebene P, die senkrecht zu seinen Hauptflächen und parallel zu den längeren Seitenflächen verläuft. Hierbei sind die vier Generatoren paarweise jeweils symmetrisch bezüglich der Symmetrieebene S und symmetrisch bezüglich der Symmetrieebene P angeordnet. Dementsprechend sind sowohl die beiden Generatoren G1 und G2, als auch die beiden Generatoren G3 und G4 symmetrisch zueinander bezüglich der Symmetrieebene S angeordnet. Weiterhin sind sowohl die Generatoren G1 und G3, als auch die Generatoren G2 und G4 symmetrisch zueinander bezüglich der Symmetrieebene P angeordnet.

Sowohl bei dem vorstehend beschriebenen Ultraschallaktor mit zwei Generatoren, als auch bei dem zuvor beschriebenen Ultraschallaktor mit vier Generatoren verlaufen die Polarisationsrichtungen des zwischen zwei benachbarten Elektroden angeordneten piezoelektrischen Materials zumindest in einer Ebene der Hauptfläche, an welcher die Elektroden angeordnet sind, senkrecht zu der Symmetrieebene S.

Es kann vorteilhaft sein, dass das Friktionselement auf einer der Stirnflächen des Ultraschallaktors angeordnet ist.

Daneben kann es vorteilhaft sein, dass zwei Friktionselemente auf einer der Hauptflächen des Ultraschallaktors angeordnet sind.

Es kann darüber hinaus vorteilhaft sein, dass wenigstens ein Friktionselement mindestens eine Längs- oder Quernut aufweist.

Ferner kann es vorteilhaft sein, dass das Verhältnis der Länge L zu der Dicke D des Ultraschallaktors im Bereich zwischen 3,5 und 4,5 liegt.

Außerdem kann es vorteilhaft sein, dass die Breite B des Ultraschallaktors größer als seine Dicke D und kleiner als seine Länge L ist.

Es kann auch vorteilhaft sein, dass der Abstand zwischen benachbarten Elektroden gleich oder kleiner als die Hälfte der Dicke D des Ultraschallaktors ist.

Die Erfindung betrifft zudem ein Verfahren zum Ansteuern eines oben bezeichneten Ultraschallmotors, wobei in der piezoelektrischen Platte bzw. in dem Ultraschallaktor gleichzeitig sowohl die zweite Mode der akustischen Biege-Stehwelle, die sich längs zu der Länge L und längs zu der Dicke D der piezoelektrischen Platte ausbreitet, als auch die erste Mode der akustischen Längs-Stehwelle, die sich längs zu der Länge L der piezoelektrischen Platte ausbreitet, angeregt werden.

Hierbei kann es von Vorteil sein, dass das Verfahren gekennzeichnet ist durch den weiteren Schritt des Bereitstellens einer elektrischen Erregerspannung, die einen Generator oder zwei Generatoren zur Anregung akustischer Stehwellen ansteuert.

Es kann hierbei ebenso von Vorteil sein, dass das Verfahren gekennzeichnet ist durch den weiteren Schritt des Bereitstellens von zwei elektrischen Erregerspannungen, die gleichzeitig zwei oder vier Generatoren zur Anregung akustischer Stehwellen ansteuern.

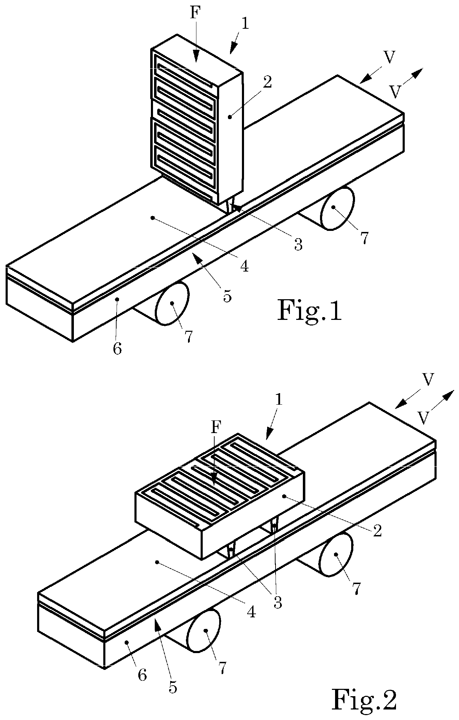

Die Abbildung in Fig. 1 zeigt eine möglich Ausführungsform eines erfindungsgemäßen Ultraschallmotors ohne Erregervorrichtung. Der Ultraschallmotor umfasst einen Ultraschallaktor 1 in Form einer rechteckigen piezoelektrischen Platte 2, an deren Stirnfläche ein Friktionselement 3 angeordnet ist, das mittels der Kraft F an die Friktionsoberfläche 4 des anzutreibenden Elements 5 angepresst wird.

Das anzutreibende Element 5 ist als ein sich längs bzw. linear bewegender Körper 6 in Form eines Stabes ausgeführt, der über das Lager 7 linear beweglich gelagert ist.

Der sich längs bzw. linear bewegende Körper 6 kann ebenso als Stange, Plattform oder als Tisch ausgeführt sein. Weitere Formen des anzutreibenden Elements 5 sind denkbar.

Die Pfeile mit dem Index V geben die Bewegungsrichtungen des anzutreibenden Elements 5 an.

Die Abbildung in Fig. 2 zeigt eine weitere mögliche Ausführungsform eines erfindungsgemäßen Ultraschallmotors ohne Erregervorrichtung, bei dem an einer der Hauptflächen des Ultraschallaktors 1 bzw. der piezoelektrischen Platte 2 zwei parallel zueinander angeordnete Friktionselemente 3 angebracht sind.

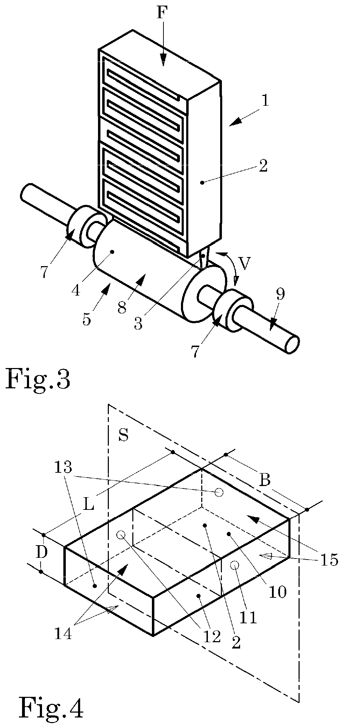

Die Abbildung in Fig. 3 zeigt eine weitere Ausführungsform eines erfindungsgemäßen Ultraschallmotors, wiederum ohne Erregervorrichtung, bei welchem das anzutreibende Element 5 als sich drehender Körper 8 in Form eines Zylinders ausgeführt ist, welcher auf einer Welle 9 angeordnet ist.

Der sich drehende Körper 8 kann ebenso als Teil eines Zylinders, als ein Ring oder als Teil eines Rings ausgeführt sein.

Fig. 4 zeigt die piezoelektrische Platte 2 des Ultraschallaktors 1. Die Platte 2 besteht vollständig aus piezoelektrischer Keramik und besitzt die zwei Hauptflächen 10, 11, die zwei längeren Seitenflächen 12 und die zwei kürzeren und Stirnflächen definierende Seitenflächen 13. Die Platte hat hierbei die Länge L, die Breite B und die Dicke D.

Das Verhältnis der Länge L zur Dicke D (d.h. L/D) ist so gewählt, dass es im Bereich von 3,5 bis 4,5 liegt.

Der zahlenmäßige Wert des Verhältnisses L/D bestimmt die Lage der Resonanzfrequenz Fp2 auf der Frequenzskala der sich ausbreitenden zweiten Mode der Stehwelle der Biegeschwingungen, die sich längs zur Länge L und längs zur Dicke D bezogen auf die Resonanzfrequenz Fp1 der ersten Mode der Stehwelle der Längsschwingungen, die sich längs zur Länge L ausbreitet.

Bei einem Verhältnis L/D = 3,5 bis 4,5 liegen die Resonanzfrequenzen Fp2 und Fp1 nah zueinander bzw. fallen zusammen.

Die Breite B der piezoelektrischen Platte 2 muss größer als seine Dicke D und kleiner als seine Länge L sein.

Die Platte kann durch die senkrechte virtuelle Symmetrieebene S, die senkrecht zu den Seitenflächen 12 und parallel zu den Stirnflächen 13 verläuft, geteilt werden. Die Symmetrieebene S teilt die Länge L und dementsprechend auch die Hauptflächen 10, 11 der Platte 2 in zwei gleich große Teile 14 und 15.

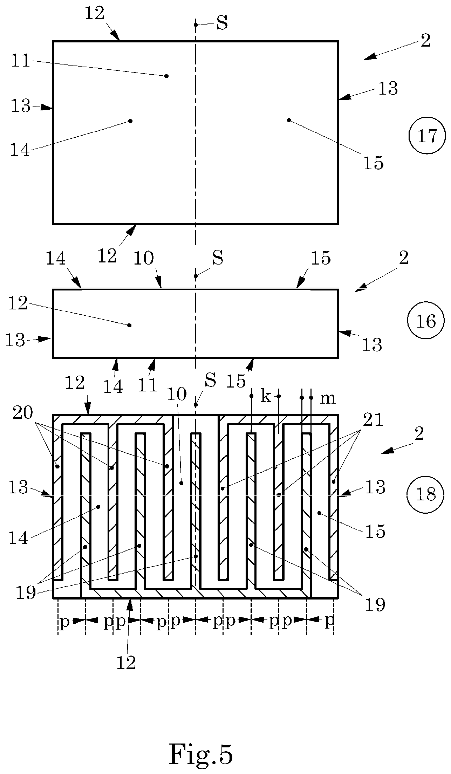

In Fig. 5 zeigt die Darstellung 16 die Seitenansicht auf die Platte 2, die Darstellung 17 die Sicht von unten auf die Platte 2 und die Darstellung 18 die Draufsicht auf die Platte 2.

Bei dieser Ausführungsform enthält die Platte 2 auf einer der Hauptflächen 10 die allgemeinen streifenförmigen Elektroden 19, die streifenförmigen Erregerelektroden 20 und die Erregerelektroden 21.

Die Erregerelektroden 20 und ein Teil der allgemeinen Elektroden 19 befinden sich im Teil 14 der Hauptfläche 10 der Platte 2.

Die Erregerelektroden 21 und ein Teil der allgemeinen Elektroden 19 befinden sich im Teil 15 der Hauptfläche 10 der Platte 2.

Die Pfeile mit dem Index p geben die Polarisationsrichtungen der Piezokeramik der Platte 2 zwischen den allgemeinen Elektroden 19 und den Erregerelektroden 20 und 21 an.

Alle streifenförmigen Elektroden 19, 20, 21 sind parallel zur Symmetrieebene S angeordnet und die Polarisationsrichtungen der Piezokeramik der piezoelektrischen Platte 2 zwischen den Elektroden 19, 20 und 21 verlaufen zumindest in der Ebene der Hauptfläche 10, an welcher die Elektroden 19, 20 und 21 angeordnet sind, senkrecht zur Symmetrieebene S.

Der Abstand k zwischen den benachbarten allgemeinen Elektroden 19 und den Erregerelektroden 20 oder 21 ist gleich oder kleiner als die Hälfte der Dicke D der piezoelektrischen Platte 2.

Die Breite m der streifenförmigen Elektroden 19, 20 und 21 liegt im Bereich von 0,1 bis 0,5 mm.

Die streifenförmigen Elektroden können auf die Hauptflächen 10, 11 der Platte 2 durch chemische Abscheidung von Chrom, Kupfer, Nickel oder durch Aufdampfen von Chrom, Kupfer oder Nickel mittels Thermovakuumverfahren oder durch Ionen-Plasma-Sputtern von Chrom, Kupfer, Nickel und Gold aufgetragen werden. Die Struktur der Elektroden kann durch Laserschneiden, durch lithografisches Ätzen oder im Siebdruckverfahren erzeugt werden.

Die Anzahl streifenförmiger Elektroden 19, 20, 21 auf den Hauptflächen 10 und 11 wird nur durch die technologischen Herstellungsmöglichkeiten begrenzt.

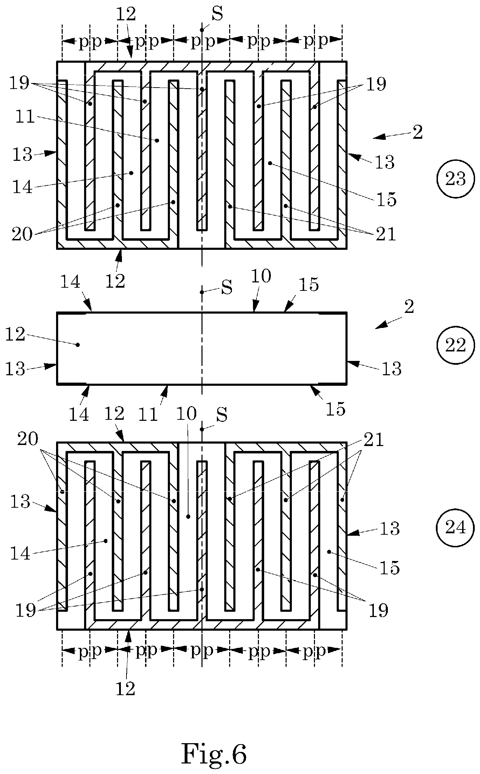

Fig. 6 zeigt eine andere Ausführungsform für die Platte 2 des Aktors 1. Die Darstellung 22 zeigt die Seitenansicht auf die Platte 2, während die Darstellung 23 die Sicht von unten auf die Platte 2 und die Darstellung 24 die Draufsicht auf die Platte 2 zeigt.

Bei dieser Ausführungsform enthält die Platte 2 auf den beiden Hauptflächen 10 und 11 die allgemeinen streifenförmigen Elektroden 19, die streifenförmigen Erregerelektroden 20 und die streifenförmigen Erregerelektroden 21.

Die Erregerelektroden 20 und ein Teil der allgemeinen Elektroden 19 sind im Teil 14 der Hauptfläche 10 der Platte 2 angeordnet (Darstellung 24).

Die Erregerelektroden 21 und ein Teil der allgemeinen Elektroden 19 sind im Teil 15 der Hauptfläche 10 der Platte 2 angeordnet (Darstellung 21).

Die Erregerelektroden 20 und ein Teil der allgemeinen Elektroden 19 sind im Teil 14 der Hauptfläche 11 der Platte 2 angeordnet (Darstellung 23).

Die Erregerelektroden 21 und ein Teil der allgemeinen Elektroden 19 sind im Teil 15 der Hauptfläche 11 der Platte 2 angeordnet (Darstellung 23).

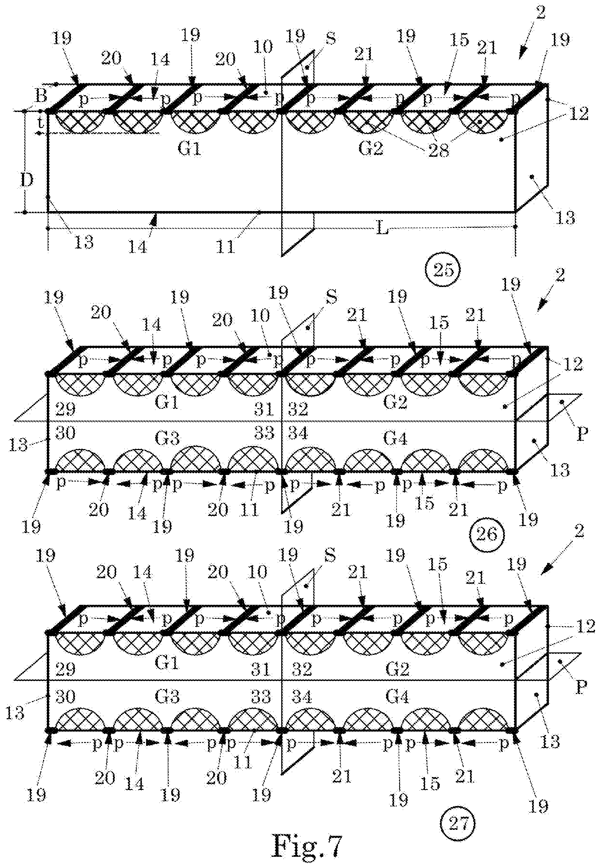

Die Darstellungen 25, 26 und 27 von Fig.7 dienen zur Erläuterung des Aufbaus der akustischen Stehwellengeneratoren von Ultraschallaktoren eines erfindungsgemäßen Ultraschallmotors.

In besagten Darstellungen zeigen die schraffierten Halbkreise 28 die polarisierten Bereiche der Piezokeramik unter den Hauptflächen 10 und 11 zwischen den allgemeinen Elektroden 19 und den Erregerelektroden 20 und 21.

In den schraffierten Bereichen reicht die Polarisation der Piezokeramik bis auf die Tiefe t der Dicke der Platte 2. Die Tiefe t hängt vom Abstand k zwischen den streifenförmigen Elektroden ab und der beträgt maximal K = 1/2D.

Die Platte 2 gemäß Darstellung 25 von Fig. 7 stellt einen Ultraschallaktor mit zwei Generatoren akustischer Stehwellen G1 und G2 dar, wobei die beiden Generatoren G1 und G2 symmetrisch zueinander bezüglich der Symmetrieebene S angeordnet sind. Die Generatoren G1 und G2 sind jeweils gebildet durch den entsprechenden Teil des polarisierten piezoelektrischen Materials der Platte 2 und den daran angeordneten streifenförmigen Elektroden 19 und 20.

Die Platte 2 gemäß den Darstellungen 26 und 27 von Fig. 7 stellen einen Ultraschallaktor mit jeweils vier Generatoren akustischer Stehwellen G1, G2, G3 und G4 dar. Hierbei weist die Platte 2 nicht nur die Symmetrieebene S, sondern noch zusätzlich die Symmetrieebene P auf, welche parallel zu den Hauptflächen 10 und 11 und senkrecht zu den Stirnflächen 13 verläuft und die Dicke D halbiert. Diese Ebene teilt die Platte 2 in zwei gleich große Teile 29 und 30.

Die Symmetrieebene S wiederum teilt den Teil 29 in die zwei gleich großen Teile 31 und 32 und den Teil 30 in die zwei gleich großen Teile 33 und 34.

Der Teil 31 der Platte 2 gehört zum Teil 14 der Hauptfläche 10 mit den allgemeinen Elektroden 19, den Erregerelektroden 20 und der polarisierten Piezokeramik zwischen ihnen, die den Generator für die akustische Stehwelle G1 bilden.

Der Teil 32 der Platte 2 gehört zum Teil 15 der Hauptfläche 10 mit den allgemeinen Elektroden 19, den Erregerelektroden 21 und der polarisierten Piezokeramik zwischen ihnen, die den Generator für die akustische Stehwelle G2 bilden.

Der Teil 33 der Platte 2 gehört zum Teil 14 der Hauptfläche 11 mit den allgemeinen Elektroden 19, den Erregerelektroden 20 und der polarisierten Piezokeramik zwischen ihnen, die den Generator für die akustische Stehwelle G3 bilden.

Der Teil 34 der Platte 2 gehört zum Teil 15 der Hauptfläche 11 mit den allgemeinen Elektroden 19, den Erregerelektroden 21 und der polarisierten Piezokeramik zwischen ihnen, die den Generator für die akustische Stehwelle G4 bilden.

Bei der in Darstellung 25 von Fig. 7 gezeigten Ausführungsform des Ultraschallaktors eines erfindungsgemäßen Ultraschallmotors stellen die Generatoren G1 und G2 sich zueinander in Phase befindende Generatoren dar.

Bei der in Darstellung 26 von Fig. 7 gezeigten Ausführungsform des Ultraschallaktors eines erfindungsgemäßen Ultraschallmotors stellen alle Generatoren G1, G2, G3 und G4 sich zueinander in Phase befindende Generatoren dar.

Bei der in Darstellung 27 gezeigten Ausführungsform des Ultraschallaktors eines efindungsgemäßen Ultraschallmotors stellen alle Generatoren G1, G2 und G4 sich zueinander in Phase befindende Generatoren dar, während der Generator G3 im Verhältnis zu den Generatoren G1, G2 und G4 einen gegenphasigen Generator darstellt. Dementsprechend unterscheiden sich die Polarisationsrichtungen des piezokeramischen Materials zwischen benachbarten Elektroden 19 und 20 der Hauptfläche 11 bezüglich des Generators G3 von den entsprechenden Polarisationsrichtungen beim piezoelektrischen Material der Generatoren G1, G2 und G4.

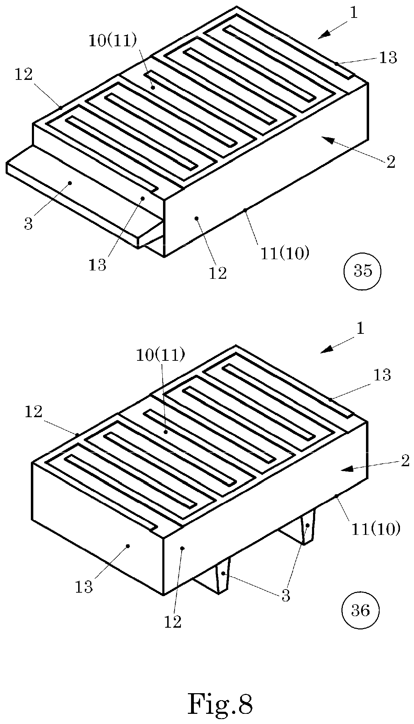

Die Darstellung 35 von Fig. 8 zeigt einen Ultraschallaktor 1 für einen erfindungsgemäßen Ultraschallmotor, in dem ein Friktionselement 3 auf einer der Stirnflächen 13 der piezoelektrischen Platte 2 angeordnet ist.

Die Darstellung 36 von Fig. 8 zeigt einen Ultraschallaktor 1 für einen erfindungsgemäßen Ultraschallmotor, in dem zwei Friktionselemente 3 auf einer der Hauptflächen 11 oder 10 der piezoelektrischen Platte 2 angeordnet sind.

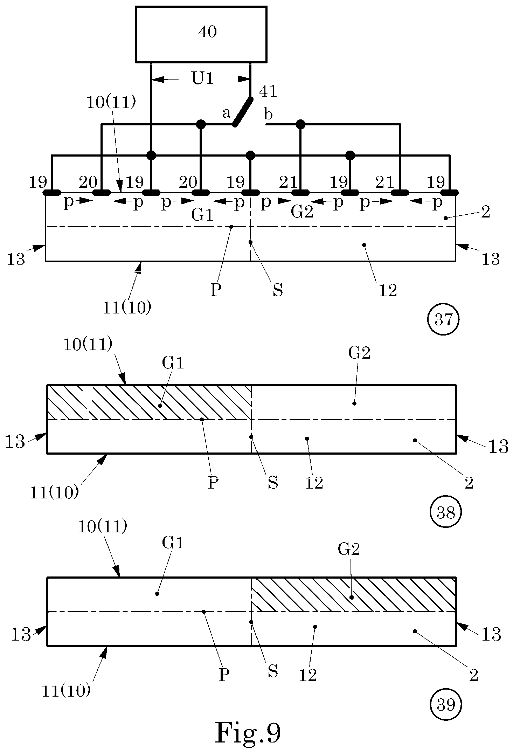

Die Darstellung 37 von Fig. 9 zeigt den Schaltplan betreffend eine mögliche elektrische Verbindung eines Ultraschallaktors 1 mit zwei Generatoren G1 und G2 (gemäß Darstellung 25 von Fig. 7) eines erfindungsgemäßen Ultraschallmotors 1 mit einer elektrischen Erregervorrichtung 40. Die elektrische Erregervorrichtung 40 stellt eine elektrische Wechselspannung U1 bereit, deren Frequenz Fg gleich der Frequenz Fp2 oder der Frequenz Fp1 ist oder zwischen diesen beiden Frequenzen oder nah zu diesen Frequenzen liegt.

Die elektrische Schaltung gemäß Darstellung 37 von Fig. 9 umfasst einen Umschalter 41. Wenn sich der Umschalter 41 in der Stellung a befindet, wird der Generator G1 angeregt; befindet sich der Umschalter 41 in der Stellung b, wird hingegen der Generator G2 angeregt. Die entsprechend angeregten Generatoren sind in den Darstellungen 38 und 39 von Fig. 9 durch eine Schraffur gekennzeichnet.

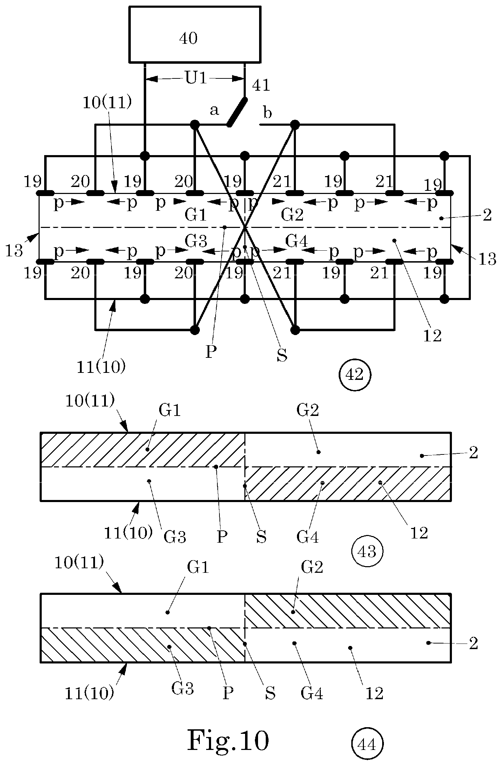

Die Darstellung 42 von Fig. 10 zeigt den Schaltplan betreffend eine mögliche elektrische Verbindung eines Ultraschallaktors 1 eines erfindungsgemäßen Ultraschallmotors mit vier Generatoren G1, G2, G3 und G4 (gemäß Darstellung 26 von Fig. 7) mit einer elektrischen Erregervorrichtung 40. Die elektrische Erregervorrichtung 40 stellt hierbei eine elektrische Wechselspannung U1 mit der Frequenz Fg bereit.

Die elektrische Schaltung gemäß Darstellung 42 von Fig. 10 umfasst einen Umschalter 41. Wenn sich der Umschalter in der Stellung a befindet, werden gleichzeitig die Generatoren G1 und G4 angeregt; befindet sich der Umschalter in Stellung b, so werden gleichzeitig die Generatoren G2 und G3 angeregt. Die jeweils angeregten Generatoren sind in den Darstellungen 43 und 44 von Fig. 10 durch eine Schraffur gekennzeichnet.

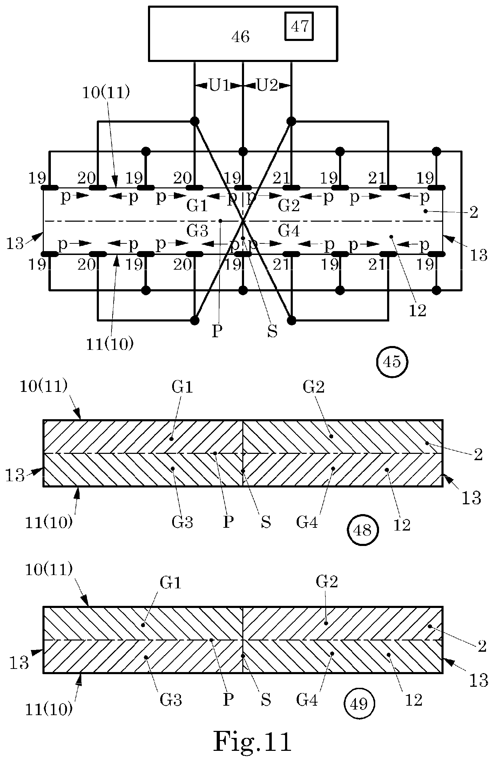

Die Darstellung 45 von Fig. 11 zeigt den Schaltplan betreffend eine mögliche elektrische Verbindung eines Ultraschallaktors 1 eines erfindungsgemäßen Ultraschallmotors mit vier Generatoren G1, G2, G3 und G4 (gemäß Darstellung 26 von Fig. 7) mit einer elektrischen Erregervorrichtung 46, welche zwei elektrische Wechselspannungen U1 und U2 mit der gleichen Frequenz Fg bereitstellt, die zueinander aber um den Phasenwinkel f verschoben sind. Die Erregervorrichtung 46 verfügt über eine Nachstimmeinrichtung 47 zur Änderung des Phasenverschiebungswinkels f.

Die Generatoren G1 und G4 werden mit der Spannung U1 angesteuert bzw. angeregt, während die Generatoren G2 und G3 mit der Spannung U2 angesteuert bzw. angeregt werden. Die entsprechend angeregten Generatoren sind in den Darstellungen 48 und 49 in Fig. 11 durch eine Schraffur gekennzeichnet.

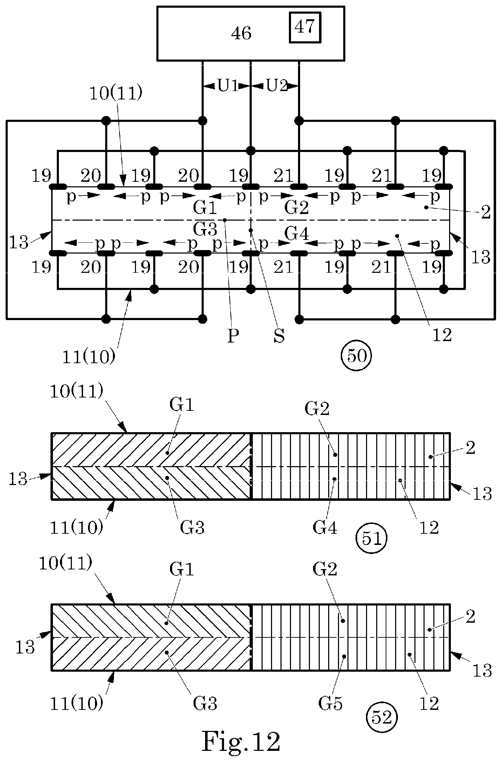

Die Darstellung 50 von Fig. 12 zeigt den Schaltplan betreffend eine mögliche elektrische Verbindung eines Ultraschallaktors 1 eines erfindungsgemäßen Ultraschallmotors mit der elektrischen Erregervorrichtung 46. Bei dieser Ausführungsform verfügt die piezoelektrische Platte 2 bzw. der Ultraschallaktor 1 über vier Generatoren G1, G2, G3 und G4 für die akustischen Stehwellen (gemäß Darstellung 27 von Fig. 7). Die elektrische Erregervorrichtung 46 stellt die zwei elektrischen Wechselspannungen U1 und U2 mit der gleichen Frequenz Fg bereit, die zueinander um den Winkel f phasenverschoben sind. Die Erregervorrichtung 46 verfügt über eine Nachstimmeinrichtung 47zur Änderung des Phasenverschiebungswinkels f.

Über die Spannung U1 werden die Generatoren G1 und G3, und über die Spannung U2 werden die Generatoren G2 und G4 angesteuert. Die entsprechend angeregten Generatoren sind in den Darstellungen 51 und 52 von Fig. 12 durch eine Schraffur gekennzeichnet. Die Generatoren G1 und G3 stellen hierbei gegenphasige Generatoren dar. Die Generatoren G2 und G4 sind hingegen zueinander in Phase.

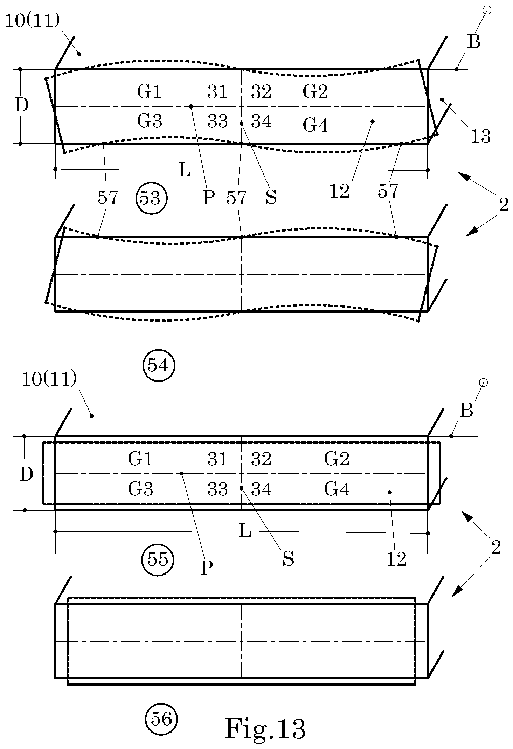

Die punktierten Linien in den Darstellungen 53 und 54 von Fig. 13 zeigen die Form einer in der Platte 2 durch elektrische Anregung der Generatoren erzeugten und sich längs zur Länge L und der Dicke D der Platte 2 sich ausbreitenden Biege-Stehwelle.

Die punktierten Linien in den Darstellungen 55 und 56 von Fig. 13 zeigen die Form einer in der Platte 2 durch elektrische Anregung der Generatoren erzeugten und sich längs zur Länge L der Platte 2 ausbreitenden Längs-Stehwelle.

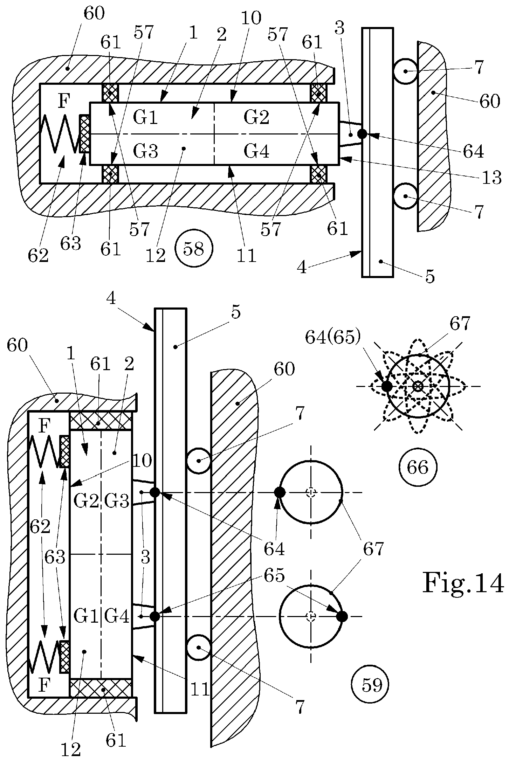

Die Darstellungen 58 und 59 von Fig. 14 zeigen zwei unterschiedliche mögliche Ausführungsformen für einen erfindungsgemäßen Ultraschallmotor.

In der ersten Ausführungsform gemäß Darstellung 58 verfügt der Ultraschallaktor 1 über ein auf der Stirnfläche 13 der Platte 2 befestigtes Friktionselement 3. Der Aktor 1 ist im Gehäuse 60 mittels schallisolierter Anschläge 61 angeordnet und wird mit der Feder 62 über die Friktionselemente 3 an die Friktionsschicht 4 des anzutreibenden Elements 5 angepresst.

In der zweiten Ausführungsform gemäß Darstellung 59 verfügt der Aktor 1 über zwei auf einer der Hauptflächen 10 oder 11 der Platte 2 befestigte Friktionselemente 3. Die Friktionselemente 3 werden mit den zwei Federn 62 an die Friktionsschicht 4 des anzutreibenden Elements 5 angepresst.

In beiden Ausführungsformen wirken die Federn 62 über die schallisolierten Elemente 63 auf den Aktor 1 ein.

Die auf den Friktionselementen 3 befindlichen Punkte 64 und 65 der Aktoren 1 befinden sich in Kontakt mit der Friktionsoberfläche 4 des anzutreibenden Elements 5.

Die Darstellungen 59 und 66 von Fig. 14 zeigen die kreisförmigen Bewegungsbahnen 67 der Punkte 64 und 65. Die gestrichelten Linien in der Position 66 zeigen weitere mögliche Formen der Bewegungsbahn der Punkte 64 und 65.

Der erfindungsgemäße Ultraschallmotor arbeitet folgendermaßen: sobald die von der elektrischen Erregervorrichtung 40 bereitgestellte Spannung U1 (siehe Darstellung 37 von Fig. 9) an den allgemeinen Elektroden 19 und den Erregerelektroden 20 des Generators G1 anliegt, bewirkt der umgekehrte piezoelektrische Effekt eine Kompression und eine Streckung der sich zwischen den Elektroden 19 und 20 im Teil 31 der Platte 2 befindenden piezokeramischer Bereiche. Der Teil 30 verhält sich hingegen passiv und wird elektrisch nicht deformiert. Infolgedessen bewirkt die Deformation des Teils 32 eine Verbiegung der Platte 2.

Da die Frequenz Fg der Spannung U1 gleich der Frequenz Fp2 oder der Frequenz Fp1 ist oder sich zwischen diesen beiden Frequenzen oder nah zu diesen Frequenzen liegt, wird in der piezoelektrischen Platte die zweite Mode einer Biege-Stehwelle erzeugt (siehe Darstellungen 53 und 54 von Fig.13). Gleichzeitig erzeugt der Generator G1 die erste Mode einer Längs-Stehwelle (siehe Darstellungen 55 und 56 von Fig.13).

Die Erzeugung dieser Wellen ist dadurch bedingt, dass sich der Generator G1 im Bereich der linken positiven Halbwelle der Biege-Stehwelle und im Bereich der der linken positiven Viertelwelle der Längs-Stehwelle befindet (siehe Fig.13).

Die Überlagerung der in der Platte 2 durch den Generator G1 erzeugten Schwingungen führt dazu, dass die Punkte 64, 65 des einen Friktionselements 3 oder der beiden Friktionselemente 3, das/die an die Friktionsoberfläche 4 angepresst ist/sind, sich auf kreisförmigen 67 oder elliptischen Bewegungsbahnen (gestrichelt dargestellt) bewegen (siehe Fig. 14).

Die Form der Bewegungsbahnen hängt von der Lage der Frequenz Fg in Bezug zu den Frequenzen F2 und F1 ab. Die Bewegungsrichtung der Punkte 64, 65 auf den Bewegungsbahnen hängt vom Phasenverschiebungswinkel der Biege-Stehwelle bezogen zur Phase der Längs-Stehwelle ab.

Beim Betätigen des Umschalters 40 wird der Generator G2 angesteuert. Dadurch ändert sich das Vorzeichen des Phasenverschiebungswinkels der Biege-Stehwelle in Bezug zur Phase der Längs-Stehwelle. Die Änderung des Winkels hat eine Umkehr der Bewegungsrichtung der Punkte 64, 65 auf ihren Bewegungsbahnen zur Folge.

Die Bewegung der Punkte 64, 65 auf den geschlossenen Bewegungsbahnen führt zum Entstehen einer Kraft, die durch den Aktor 1 auf das anzutreibende Element 5 wirkt, wodurch sich das anzutreibende Element 5 in Bewegungsrichtung der Punkte 64, 65 bewegt. Eine Änderung der Bewegungsrichtung der Punkte 64, 65 führt zu einer Umkehr der Bewegungsrichtung des anzutreibenden Elements 5.

Bei der in Darstellung 42 von Fig. 10 dargestellten Ausführungsform einer piezoelektrischen Platte werden die akustischen Wellen durch die zwei Generatoren G1 und G4, oder durch die beiden Generatoren G2 und G3 erzeugt, die jeweils parallel geschaltet sind. Das Anregungsprinzip ist das gleiche wie in der vorhergehenden Konstruktionsvariante.

Durch die parallele Anregung der zwei Generatoren G1 und G4 oder der beiden Generatoren G2 und G3 ist es möglich, den Pegel der elektrischen Erregerspannung U1 um etwa das 2-fache zu verringern.

Wie in Fig. 11 dargestellt, ist auch die Verwendung einer elektrischen Zweiphasenerregervorrichtung 46 möglich, die die zwei elektrischen Erregerspannungen U1 und U2 zur gleichzeitigen Anregung der vier Generatoren G1, G4 und G2, G3 des Aktors 1 bereitstellt. Das Anregungsprinzip zur Generierung der Wellen ist das gleiche wie in den zwei vorhergehenden Beispielen.

Die elektrische Zweiphasenerregervorrichtung 46 kann die Nachstimmeinrichtung 47 enthalten, die eine elektrische Steuerung der Form der Bewegungsbahn der Punkte 64 und 65 und deren Bewegungsrichtung auf den Bewegungsbahnen ermöglicht.

Weiterhin ist eine unabhängige zweiphasige Erregung des Aktors 1 möglich, wobei in der piezoelektrischen Platte 2 durch die elektrische Spannung U1 eine akustische Biege-Stehwelle und durch die elektrische Spannung U2 eine akustische Längs-Stehwelle erzeugt werden.

In diesen Fall ist die piezoelektrische Platte 2 mit einen gegenphasigen Generator G3 und drei sich in Phase befindlichen Generatoren G1, G2 und G4 (siehe Darstellung 27 von Fig. 7) ausgestattet. Die elektrische Spannung U1 regt die zwei parallel geschalteten Generatoren G1 und G3 und die elektrische Spannung U2 regt die zwei parallel geschalteten Generatoren G2 und G4 an (siehe auch Fig. 12).

Die Generatoren G1 und G3 erzeugen eine akustische Biege-Stehwelle, während die Generatoren G2 und G4 erzeugen eine akustische Längs-Stehwelle erzeugen.

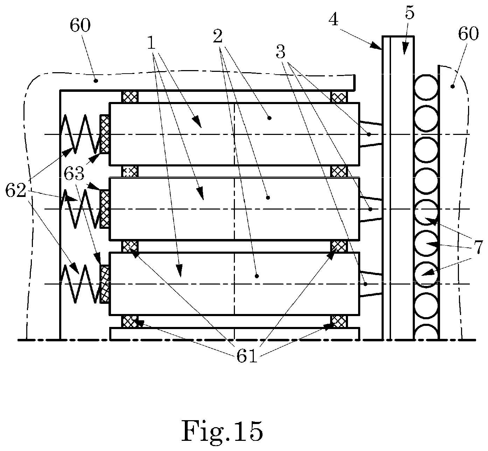

Gemäß Fig. 15 kann der erfindungsgemäße Ultraschallmotor zwei oder mehr in einem gemeinsamen Gehäuse 60 untergebrachte Ultraschallaktoren 1 aufweisen. Bei einer solchen Ausführungsform ist es möglich, proportional zur Anzahl der Aktoren die Bewegungs- und Haltekraft des Motors zu erhöhen.

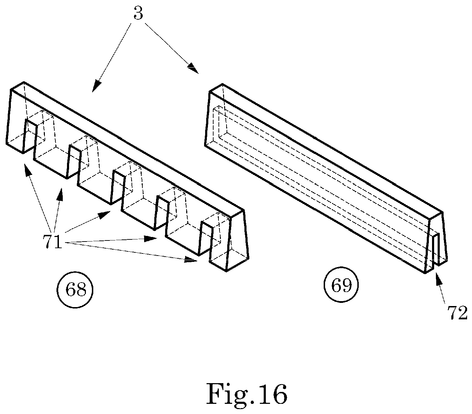

Gemäß den Darstellungen 68 und 69 von Fig. 16 können die Friktionselemente 3 des Aktors 1 des erfindungsgemäßen Ultraschallmotors ein oder mehrere Quernuten 71 oder eine Längsnut 72 aufweisen. Eine Kombination der beiden Nutenarten ist ebenso denkbar. Das ermöglicht es, die Unterschiede in den Temperaturausdehnungskoeffizienten der Piezokeramik der Platte 2 und des Materials, aus dem die Friktionselemente 3 gefertigt wurden und deren Auswirkungen zu verringern.

Im Vergleich zum bekannten Stand der Technik ist es durch den erfindungsgemäßen Ultraschallmotor möglich, die Breite der piezoelektrischen Platte des Aktors auf ein Mehrfaches zu vergrößern. Dadurch erhöht sich sowohl die maximale durch den Motor erzeugte Kraft, als auch die mechanische Motorleistung. Außerdem kann anstatt mehrerer bislang erforderlicher Motoren mit niedriger Leistung nur ein erfindungsgemäßer Ultraschallmotor mit einem Ultraschallaktor verwendet werden.

Wenn der Motor nur einen Ultraschallaktor aufweist, ist es wesentlich leichter möglich, einen stabilen Betrieb zu gewährleisten, sowie dessen Erregerfrequenz zu stabilisieren.

Überdies verringern sich bei einem Einsatzes nur eines Ultraschallmotors die Kosten für das Antriebssystem sowie für das Gerät, in dem ein solcher Ultraschallmotor verwendet wird.

## Patentansprüche

1. Ultraschallmotor, umfassend
- einen Ultraschallaktor (1) in Form einer rechteckigen Platte (2) mit einer Länge L, einer Breite B und einer Dicke D aus piezoelektrischem Material mit zwei Hauptflächen (10, 11), zwei längeren Seitenflächen (12) und zwei kürzeren Seitenflächen, welche Stirnflächen (13) definieren;
- ein anzutreibendes Element (5); und
- eine elektrische Erregervorrichtung (40, 46);
wobei an dem Ultraschallaktor (1) wenigstens ein an das anzutreibende Element (5) gedrücktes Friktionselement (3) angeordnet ist,
**dadurch gekennzeichnet, dass** der Ultraschallaktor (1) zwei Generatoren G1, G2 zur Anregung von akustischen Stehwellen in diesem umfasst, wobei jeder der Generatoren G1, G2 gebildet ist aus dem entsprechenden Teil des piezoelektrischen Materials des Ultraschallaktors (1) und daran abwechselnd angeordneten streifenförmigen allgemeinen Elektroden (19) und Erregerelektroden (20, 21), wobei der Ultraschallaktor (1) eine Symmetrieebene S aufweist, die senkrecht zu seinen längeren Seitenflächen (12) und parallel zu seinen Stirnflächen (13) verläuft, wobei die streifenförmigen Elektroden (19, 20, 21) parallel zu der Symmetrieebene S an einer der Hauptflächen (10, 11) angeordnet sind, die zwei Generatoren G1, G2 symmetrisch bezüglich der Symmetrieebene S angeordnet sind und entlang dieser aneinander angrenzen, und die Polarisationsrichtungen p des zwischen zwei benachbarten Elektroden (19, 20, 21) angeordneten piezoelektrischen Materials zumindest in einer Ebene der Hauptfläche (10, 11), an welcher die Elektroden (19, 20, 21) angeordnet sind, senkrecht zu der Symmetrieebene S verlaufen.

2. Ultraschallmotor nach Anspruch 1, **dadurch gekennzeichnet, dass** der Ultraschallaktor (1) zwei zusätzliche Generatoren G3, G4 zur Anregung von akustischen Stehwellen in diesem umfasst, wobei jeder der zusätzlichen Generatoren G3, G4 gebildet ist aus dem entsprechenden Teil des piezoelektrischen Materials des Ultraschallaktors (1) und daran abwechselnd angeordneten streifenförmigen allgemeinen Elektroden (19) und Erregerelektroden (20, 21), und wobei der Ultraschallaktor (1) eine zusätzliche Symmetrieebene P aufweist, die parallel zu seinen Hauptflächen (10, 11) und senkrecht zu den längeren Seitenflächen (12) verläuft, und die beiden zusätzlichen Generatoren G3, G4 symmetrisch zu den Generatoren G1, G2 bezüglich der Symmetrieebene P angeordnet sind.

3. Ultraschallmotor nach Anspruch 1 oder 2, **dadurch gekennzeichnet, dass** das Friktionselement (3) auf einer der Stirnflächen (13) des Ultraschallaktors (1) angeordnet ist.

4. Ultraschallmotor nach Anspruch 1 oder 2, **dadurch gekennzeichnet, dass** zwei Friktionselemente (3) auf einer der Hauptflächen (10, 11) des Ultraschallaktors (1) angeordnet sind.

5. Ultraschallmotor nach einem der vorhergehenden Ansprüche, **dadurch gekennzeichnet, dass** wenigstens ein Friktionselement (3) mindestens eine Quernut (71) oder eine Längsnut (72) aufweist.

6. Ultraschallmotor nach einem der vorhergehenden Ansprüche, **dadurch gekennzeichnet, dass** das Verhältnis von der Länge L zu der Dicke D des Ultraschallaktors (1) im Bereich zwischen 3,5 und 4,5 liegt.

7. Ultraschallmotor nach einem der vorhergehenden Ansprüche, **dadurch gekennzeichnet, dass** die Breite B des Ultraschallaktors (1) größer als seine Dicke D und kleiner als seine Länge L ist.

8. Ultraschallmotor nach einem der vorhergehenden Ansprüche, **dadurch gekennzeichnet, dass** der Abstand k zwischen benachbarten Elektroden (19, 20, 21) gleich oder kleiner als die Hälfte der Dicke D des Ultraschallaktors (1) ist.

9. Verfahren zum Ansteuern eines Ultraschallmotors nach einem der vorhergehenden Ansprüche, **dadurch gekennzeichnet, dass** in der piezoelektrischen Platte (2) gleichzeitig sowohl die zweite Mode der akustischen Biege-Stehwelle, die sich längs zu ihrer Länge L und längs zu ihrer Dicke D ausbreitet, als auch die erste Mode der akustischen Längs- Stehwelle, die sich längs zu ihrer Länge L ausbreitet, angeregt werden.

10. Verfahren nach Anspruch 9, **gekennzeichnet durch** das Bereitstellen einer elektrischen Erregerspannung, die einen Generator oder zwei Generatoren für akustische Stehwellen ansteuert.

11. Verfahren nach Anspruch 9, **gekennzeichnet durch** das Bereitstellen von zwei elektrischen Erregerspannungen, die gleichzeitig zwei oder vier Generatoren für akustische Stehwellen ansteuern.

## Claims

1. An ultrasonic motor, comprising
- an ultrasonic actuator (1) in the form of a rectangular plate (2) with a length L, a width B and a thickness D formed from piezoelectric material with two main faces (10, 11), two longer lateral faces (12) and two shorter lateral faces which define end faces (13);
- an element (5) to be activated; and
- an electrical excitation device (40, 46);
wherein at least one frictional element (3) pressed onto the element (5) to be actuated is disposed on the ultrasonic actuator (1),
**characterized in that**
the ultrasonic actuator (1) comprises two generators G1, G2 in order to excite acoustic standing waves therein, wherein each of the generators G1, G2 is formed by the corresponding portion of the piezoelectric material of the ultrasonic actuator (1) and general electrodes (19) and excitation electrodes (20, 21) in the form of strips disposed alternately thereon, wherein the ultrasonic actuator (1) has a plane of symmetry S which extends perpendicularly to its longer lateral face (12) and parallel to its end face (13),
wherein the electrodes (19, 20, 21) in the form of strips are disposed on one of the main faces (10, 11) parallel to the plane of symmetry S, the two generators G1, G2 are disposed symmetrically with respect to the plane of symmetry S and border each other along it and, at least in a plane of the main face (10, 11) on which the electrodes (19, 20, 21) are disposed, the polarisation directions of the piezoelectric material which is disposed between two adjacent electrodes (19, 20, 21) extend perpendicularly to the plane of symmetry S.

2. The ultrasonic motor as claimed in claim 1, **characterized in that** the ultrasonic actuator (1) comprises two additional generators G3, G4 in order to excite acoustic standing waves therein, wherein each of the additional generators G3, G4 is formed from the corresponding portion of the piezoelectric material of the ultrasonic actuator (1) and general electrodes (19) and excitation electrodes (20, 21) in the form of strips disposed alternately thereon, and wherein the ultrasonic actuator (1) has an additional plane of symmetry P which extends parallel to its main faces (10, 11) and perpendicular to the longer lateral faces (12), and the two additional generators G3, G4 are disposed symmetrically to the generators G1, G2 with respect to the plane of symmetry P.

3. The ultrasonic motor as claimed in claim 1 or claim 2, **characterized in that** the frictional element (3) is disposed on one of the end faces (13) of the ultrasonic actuator (1).

4. The ultrasonic motor as claimed in claim 1 or claim 2, **characterized in that** two frictional elements (3) are disposed on one of the main faces (10, 11) of the ultrasonic actuator (1).

5. The ultrasonic motor as claimed in one of the preceding claims, **characterized in that** at least one frictional element (3) has at least one transverse groove (71) or longitudinal groove (72).

6. The ultrasonic motor as claimed in one of the preceding claims, **characterized in that** the ratio of the length L to the thickness D of the ultrasonic actuator (1) is in the range between 3.5 and 4.5.

7. The ultrasonic motor as claimed in one of the preceding claims, **characterized in that** the width B of the ultrasonic actuator (1) is larger than its thickness D and smaller than its length L.

8. The ultrasonic motor as claimed in one of the preceding claims, **characterized in that** the distance k between neighbouring electrodes (19, 20, 21) is greater than or equal to half the thickness D of the ultrasonic actuator (1).

9. A method for controlling an ultrasonic motor as claimed in one of the preceding claims, **characterized in that** in the piezoelectric plate (2), both the second acoustic bending standing wave mode which propagates longitudinally to its length L and longitudinally to its thickness D and also the first acoustic longitudinal standing wave mode which propagates longitudinally to its length L are excited simultaneously.

10. The method as claimed in claim 9, **characterized by** the provision of an electrical excitation voltage which controls one or two acoustic standing wave generators.

11. The method as claimed in claim 9, **characterized by** the provision of two electrical excitation voltages which simultaneously control two or four acoustic standing wave generators.

## Revendications

1. Moteur à ultrasons, comprenant
- un actionneur à ultrasons (1) sous la forme d'une plaque rectangulaire (2) présentant une longueur L, une largeur B et une épaisseur D, en matériau piézoélectrique avec deux surfaces principales (10, 11), deux surfaces latérales longues (12) et deux surfaces latérales courtes qui définissent des surfaces terminales (13) ;
- un élément à entraîner (5) ; et
- un dispositif d'excitation électrique (40, 46) ;
dans lequel au moins un élément à friction (3) plaqué contre l'élément à entraîner (5) est agencé au niveau de l'actionneur à ultrasons (1),
**caractérisé en ce que**
l'actionneur à ultrasons (1) comprend deux générateurs G1, G2 permettant l'excitation d'ondes acoustiques stationnaires au sein de celui-ci,
dans lequel chacun des générateurs G1, G2 est formé de la partie correspondante du matériau piézoélectrique de l'actionneur à ultrasons (1) ainsi que d'électrodes génériques (19) et d'électrodes d'excitation (20, 21), en forme de bande, agencées de manière alternée sur ladite partie correspondante du matériau piézoélectrique de l'actionneur à ultrasons, dans lequel l'actionneur à ultrasons (1) présente un plan de symétrie S qui s'étend perpendiculairement à ses surfaces latérales longues (12) et parallèlement à ses surfaces terminales (13),
dans lequel les électrodes en forme de bande (19, 20, 21) sont agencées parallèlement au plan de symétrie S au niveau d'une des surfaces principales (10, 11), les deux générateurs G1, G2 sont agencés symétriquement par rapport au plan de symétrie S et sont adjacents l'un à l'autre le long dudit plan de symétrie S, et les directions de polarisation p du matériau piézoélectrique agencé entre deux électrodes (19, 20, 21) adjacentes s'étendent perpendiculairement au plan de symétrie S au moins dans un plan de la surface principale (10, 11) au niveau de laquelle sont agencées les électrodes (19, 20, 21).

2. Moteur à ultrasons selon la revendication 1, **caractérisé en ce que** l'actionneur à ultrasons (1) comprend deux générateurs G3, G4 supplémentaires permettant l'excitation d'ondes acoustiques stationnaires au sein de celui-ci, dans lequel chacun des générateurs G3, G4 supplémentaires est formé de la partie correspondante du matériau piézoélectrique de l'actionneur à ultrasons (1) ainsi que d'électrodes génériques (19) et d'électrodes d'excitation (20, 21), en forme de bande, agencées de manière alternée sur ladite partie correspondante du matériau piézoélectrique de l'actionneur à ultrasons, et dans lequel l'actionneur à ultrasons (1) présente un plan supplémentaire de symétrie P qui s'étend parallèlement à ses surfaces principales (10, 11) et perpendiculairement aux surfaces latérales longues (12), et les deux générateurs G3, G4 supplémentaires sont agencés de manière symétrique par rapport aux générateurs G1, G2 et au plan de symétrie P.

3. Moteur à ultrasons selon la revendication 1 ou 2, **caractérisé en ce que** l'élément à friction (3) est agencé sur une des surfaces terminales (13) de l'actionneur à ultrasons (1).

4. Moteur à ultrasons selon la revendication 1 ou 2, **caractérisé en ce que** deux éléments à friction (3) sont agencés sur une des surfaces principales (10, 11) de l'actionneur à ultrasons (1).

5. Moteur à ultrasons selon l'une quelconque des revendications précédentes, **caractérisé en ce qu'**au moins un élément à friction (3) présente au moins une rainure transversale (71) ou une rainure longitudinale (72).

6. Moteur à ultrasons selon l'une quelconque des revendications précédentes, **caractérisé en ce que** le rapport de la longueur L sur l'épaisseur D de l'actionneur à ultrasons (1) est compris entre 3,5 et 4,5.

7. Moteur à ultrasons selon l'une quelconque des revendications précédentes, **caractérisé en ce que** la largeur B de l'actionneur à ultrasons (1) est supérieure à son épaisseur D et inférieure à sa longueur L.

8. Moteur à ultrasons selon l'une quelconque des revendications précédentes, **caractérisé en ce que** la distance k entre des électrodes (19, 20, 21) adjacentes est inférieure ou égale à la moitié de l'épaisseur D de l'actionneur à ultrasons (1).

9. Procédé de commande d'un moteur à ultrasons selon l'une quelconque des revendications précédentes, **caractérisé en ce que** le second mode de l'onde stationnaire acoustique de flexion qui se propage le long de la longueur L et le long de l'épaisseur D de la plaque piézoélectrique et le premier mode de l'onde stationnaire longitudinale acoustique qui se propage le long de la longueur L de la plaque piézoélectrique peuvent être excités de manière simultanée au sein de la plaque piézoélectrique (2).

10. Procédé selon la revendication 9, **caractérisé par** la fourniture d'une tension électrique d'excitation qui commande un générateur ou deux générateurs d'ondes stationnaires acoustiques.

11. Procédé selon la revendication 9, **caractérisé par** la fourniture de deux tensions électriques d'excitation qui commandent simultanément deux ou quatre générateurs d'ondes stationnaires acoustiques.
